# EUROPEAN PATENT APPLICATION

(11) **EP 4 293 313 A1**
(43) Date of publication of application: **20.12.2023**
(21) Application number: 23178781.3
(22) Date of filing: 12.06.2023
(51) Int. Cl.: F41H 13/00, H05K 7/14, H05K 7/20

(54) **COLD PLATE THERMAL STORAGE FOR HIGH LOAD SHORT DURATION COOLING**

(30) Priority: 13.06.2022 US 202217838704
(71) Applicant: Hamilton Sundstrand Corporation, Charlotte, NC 28217-4578 (US)
(72) Inventor: VIGNALI, Mark G., Simsbury, CT (US)
(74) Representative: Dehns

(57) **Abstract**

A thermal management system (20) for a directed energy weapon (22) includes a heat transfer assembly (24) thermally coupled to the directed energy weapon. The heat transfer assembly includes a phase change material (36). The thermal management system further includes a secondary system (26) and a thermal management fluid (R) circulating through a closed loop fluidly coupled to the heat transfer assembly and the secondary system. A mode of operation of the directed energy weapon is dependent on a condition of the phase change material.

## Description

### BACKGROUND

Exemplary embodiments of the present disclosure relate to the art of a thermal management system, and more specifically, to a thermal management system for removing heat from a directed energy weapon (DEW).

Vehicles, such as aircraft, are being designed with advanced weapons like laser based direct energy weapons (DEWs). DEWs (e.g., laser weapons) may require substantial cooling at the lowest possible weight for sustained operation. DEWs typically operate at low efficiency and thus, generate a large amount of heat during operation, such as when the weapon is firing. DEW operation typically consists of relatively brief operating intervals, wherein relatively large "bursts" of cooling are required, interspersed with relatively long intervals in which the weapon is quiescent, and therefore, requires little or no cooling. This large thermal transient may drive the size of the thermal management system used to control the thermal loading of the DEW. Such requirements may result in a thermal management system that is significantly oversized, inefficient and heavy for normal operating (non-lasing) modes. Therefore, a fast and efficient thermal management system is desired to address the thermal load of a DEW and to protect onboard components from thermal transients.

### BRIEF DESCRIPTION

According to an embodiment, a thermal management system for a directed energy weapon includes a heat transfer assembly thermally coupled to the directed energy weapon. The heat transfer assembly includes a phase change material. The thermal management system further includes a secondary system and a thermal management fluid circulating through a closed loop fluidly coupled to the heat transfer assembly and the secondary system. A mode of operation of the directed energy weapon is dependent on a condition of the phase change material.

In addition to one or more of the features described above, or as an alternative to any of the foregoing embodiments the heat transfer assembly includes a cold plate and the directed energy weapon is thermally coupled to a surface of the cold plate.

In addition to one or more of the features described above, or as an alternative to any of the foregoing embodiments the phase change material is embedded within an interior of the cold plate.

In addition to one or more of the features described above, or as an alternative to any of the foregoing embodiments the heat transfer assembly further comprises a fluid flow path formed in the cold plate. The fluid flow path is operable to receive the thermal management fluid.

In addition to one or more of the features described above, or as an alternative to any of the foregoing embodiments the phase change material is positioned centrally between the fluid flow path and the directed energy weapon.

In addition to one or more of the features described above, or as an alternative to any of the foregoing embodiments the fluid flow path further comprises an inlet arranged at a first side of the cold plate and an outlet arranged at a second side of the cold plate. The second side is distinct from the first side.

In addition to one or more of the features described above, or as an alternative to any of the foregoing embodiments the directed energy weapon is operable in a firing mode. During operation in the firing mode, an amount of heat generated by the directed energy weapon exceeds an amount of heat that can be removed from the heat transfer assembly by the thermal management fluid.

In addition to one or more of the features described above, or as an alternative to any of the foregoing embodiments during operation in the firing mode, the phase change material is operable to transform from a first state to a second state.

In addition to one or more of the features described above, or as an alternative to any of the foregoing embodiments the first state is a solid and the second state is a liquid.

In addition to one or more of the features described above, or as an alternative to any of the foregoing embodiments the directed energy weapon is operable in a charging mode, and during operation in the charging mode, the amount of heat that can be removed by the thermal management fluid exceeds the amount of heat generated by the directed energy weapon.

In addition to one or more of the features described above, or as an alternative to any of the foregoing embodiments during operation in the charging mode, the phase change material is operable to transform from the second state to the first state.

In addition to one or more of the features described above, or as an alternative to any of the foregoing embodiments the phase change material is a wax.

In addition to one or more of the features described above, or as an alternative to any of the foregoing embodiments the secondary system is one of a vapor cycle and an air cycle.

In addition to one or more of the features described above, or as an alternative to any of the foregoing embodiments the secondary system further comprises a heat exchanger and the thermal management system is thermally coupled to the heat exchanger.

According to an embodiment, a method of operating a thermal management system for a directed energy weapon includes circulating a thermal management fluid through a closed loop system thermally coupled to the directed energy weapon at a heat transfer assembly including a cold plate and a phase change material and operating the directed energy weapon in a firing mode. Operating in the firing mode includes transferring heat from the directed energy weapon to the cold plate and the phase change material, removing heat from the phase change material via the thermal management fluid, and exhausting the heat of the thermal management fluid to a secondary system.

In addition to one or more of the features described above, or as an alternative to any of the foregoing embodiments during operation of the directed energy weapon in the firing mode, transforming the phase change material from a first state to a second state.

In addition to one or more of the features described above, or as an alternative to any of the foregoing embodiments comprising transforming the directed energy weapon from the firing mode to a charging mode in response to substantially all of the phase change material within the heat transfer assembly transforming from the first state to the second state.

In addition to one or more of the features described above, or as an alternative to any of the foregoing embodiments the directed energy weapon does not generate heat during the charging mode.

In addition to one or more of the features described above, or as an alternative to any of the foregoing embodiments operating the directed energy weapon in the charging mode further comprises removing heat from the phase change material via the thermal management fluid and exhausting the heat of the thermal management fluid to the secondary system.

In addition to one or more of the features described above, or as an alternative to any of the foregoing embodiments during operation of the directed energy weapon in the charging mode, transforming the phase change material from the second state to the first state.

### BRIEF DESCRIPTION OF THE DRAWINGS

The following descriptions should not be considered limiting in any way. With reference to the accompanying drawings, like elements are numbered alike:

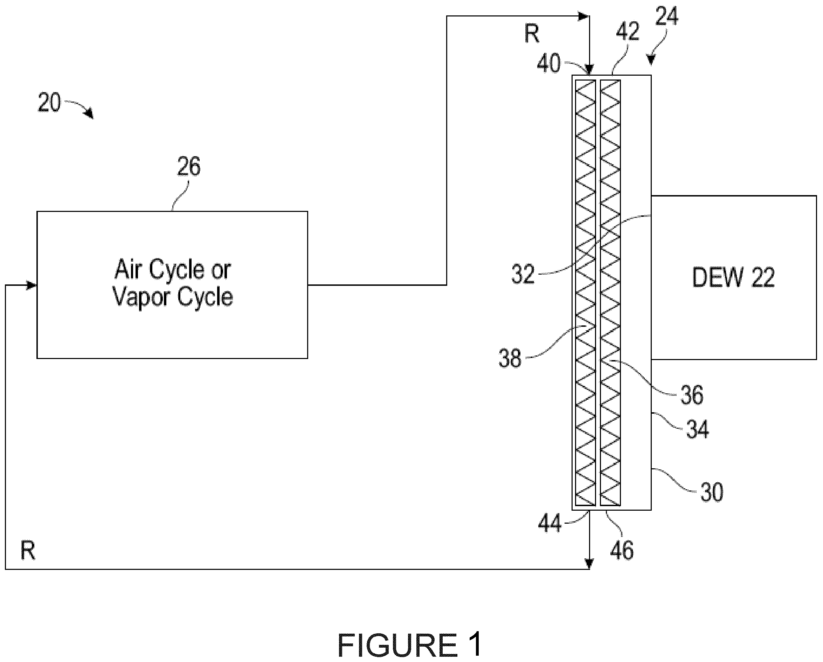

Figure 1 is a schematic diagram of a thermal management system operable to cool a directed energy weapon according to an embodiment.

### DETAILED DESCRIPTION

A detailed description of one or more embodiments of the disclosed apparatus and method are presented herein by way of exemplification and not limitation with reference to the Figures.

With reference now to the FIG. 1, an example of a thermal management system 20 is illustrated. In the illustrated, non-limiting embodiment, the thermal management system 20 is operable to manage the heat generated by a directed energy weapon (DEW) 22, such as a laser for example. In an embodiment, the thermal management system 20 and DEW 22 are integrated into a vehicle, such as a land vehicle or an aircraft for example.

The thermal management system 20 has a closed loop configuration through which a thermal management fluid R is configured to circulate. The thermal management fluid R may be air, refrigerant, ethylene glycol and water (EGW), propylene glycol and water (PGW) or another suitable fluid. In the illustrated, non-limiting embodiment, the thermal management system 20 includes a heat transfer assembly 24 arranged in thermal contact or communication with the directed energy weapon (DEW) 22 and is operable to cool or remove heat from the DEW 22. The thermal management system 20 is additionally thermally coupled to a secondary system 26 of the vehicle. In the illustrated, non-limiting embodiment, the secondary system 26 is one of a vapor cycle and an air cycle (such as a portion of an environmental control system). However, it should be understood that any suitable system of the vehicle may be used as the secondary system 26.

In the illustrated, non-limiting embodiment, the heat transfer assembly 24 includes a cold plate 30, and a heat transfer surface 32 of the DEW 22 is mounted in directed or indirect contact with a first surface 34 of the cold plate 30. Embedded within the interior of the cold plate 30 is a phase change material 36. Although any suitable phase change material 36 is contemplated herein, in an embodiment, the phase change material 36 is a wax, such as paraffin wax for example. The heat transfer assembly 24 may additionally include a fluid flow path 38 extending through the cold plate 30. An inlet 40 of the fluid flow path 38 may be formed at a first side 42 of the heat transfer assembly 24 and an outlet 44 of the fluid flow path 38 may be formed at a second, opposite side 46 of the heat transfer assembly 24. However, it should be understood that embodiments where the fluid flow path 38 makes multiple passes through the cold plate 30, and/or where the outlet 44 is arranged at the same side as the inlet 40, or alternatively, at a third side located adjacent to the first side 42 are also within the scope of the disclosure.

The fluid flow path 38 is path of the closed loop through which the thermal management fluid R circulates. The thermal management fluid R within the fluid flow path 38 is arranged in a heat exchange relationship with the phase change material 36. Accordingly, in an embodiment, the phase change material 36 is located centrally within the cold plate 30, such as at a position between the DEW 22 and the fluid flow path 38.

The thermal management system 20 is configured to discharge the heat from the DEW 22 into the secondary system 26. When the DEW 22 is operational or in a firing mode, excess heat is generated by the DEW 22. This heat is transferred from the DEW 22 to the cold plate 30. As heat is transferred to the cold plate 30, the phase change material 36 embedded within the cold plate 30 will act as a thermal storage device and absorb the heat. At the same time, a cool thermal management fluid R is provided to the fluid flow path 38 via the inlet 40 in the heat transfer assembly 24. Within the fluid flow path, the cool thermal management fluid R cools or removes heat from the phase change material 36. The heated thermal management fluid R provided at the outlet of the heat transfer assembly 24 is then circulated into thermal communication with the secondary system 26. In an embodiment, the thermal management fluid R of the thermal management system 20 is configured to circulate through a heat exchanger of the secondary system 26. However, embodiments where the thermal management fluid R is conditioned within the secondary system 26 in another suitable manner are also contemplated herein. For example, energy may be extracted from the thermal management fluid R, such as within a turbine of the secondary system 26. The cool thermal management fluid R output from the interaction with the secondary system 26 is then returned to the inlet 40 of the heat transfer assembly 24 to repeat the cycle.

When the DEW 22 is in a firing mode, the amount of heat removed from the phase change material 36 by the thermal management fluid R is less than the amount of heat generated by the DEW 22 or transferred to the phase change material 36 from the DEW 22. As a result, during operation of the DEW 22, the phase change material 36 will gradually transition from a first state, such as a solid for example, to a second state, such as a liquid for example. However, embodiments where the first state is a liquid and the second state is a gas are also contemplated herein. Such operation may continue until all of the phase change material 36 has transformed to the second state. Once all or substantially all of the phase change material P has transformed to the second state, no further cooling of the DEW 22 and/or cold plate 30 is performed by the phase change material 36, and therefore the maximum cooling of the thermal management system 20 has been reached. Accordingly, in response to the phase change material 36 being in the second state, the DEW 22 may be transformed from the firing mode to a charging or recharging (not firing) mode.

When charging, the cooling required by the DEW 22 is significantly less than required during operation of the DEW 22 in the firing mode. In an embodiment, the DEW 22 does not require any cooling when in the charging mode. As a result, the cool thermal management fluid R output from the secondary system 26 is operable to cool the phase change material 36 within the heat transfer assembly 24. This cooling of the phase change material 36 causes the phase change material 36 to transform from the second state back to the first state. Once all or substantially all of the phase change material 36 has returned to the first state, the DEW 22 may be transformed to the firing mode as desired. Accordingly, the mode of the DEW 22 may therefore be dependent on a condition, such as the temperature or state for example, of the phase change material 36 within the heat transfer assembly 24.

A thermal management system 20 having a thermal storage device as described herein allows the thermal management system to be sized based on the average cooling load for the DEW 22, rather than the maximum cooling load. In addition, the thermal management system 20 is smaller and requires less power than existing systems.

The term "about" is intended to include the degree of error associated with measurement of the particular quantity based upon the equipment available at the time of filing the application.

The terminology used herein is for the purpose of describing particular embodiments only and is not intended to be limiting of the present disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

While the present disclosure has been described with reference to an exemplary embodiment or embodiments, it will be understood by those skilled in the art that various changes may be made and equivalents may be substituted for elements thereof without departing from the scope of the present disclosure. In addition, many modifications may be made to adapt a particular situation or material to the teachings of the present disclosure without departing from the essential scope thereof. Therefore, it is intended that the present disclosure not be limited to the particular embodiment disclosed as the best mode contemplated for carrying out this present disclosure, but that the present disclosure will include all embodiments falling within the scope of the claims.

## Claims

1. A thermal management system (20) for a directed energy weapon (22) comprising:
a heat transfer assembly (24) thermally coupled to the directed energy weapon, wherein the heat transfer assembly includes a phase change material (36);
a secondary system (26); and
a thermal management fluid (R) circulating through a closed loop fluidly coupled to the heat transfer assembly and the secondary system;
wherein a mode of operation of the directed energy weapon is dependent on a condition of the phase change material.

2. The thermal management system of claim 1, wherein the heat transfer assembly (24) includes a cold plate (30) and the directed energy weapon (22) is thermally coupled to a surface of the cold plate.

3. The thermal management system of claim 2, wherein the phase change material (36) is embedded within an interior of the cold plate (30) .

4. The thermal management system of claim 2 or 3, wherein the heat transfer assembly (24) further comprises a fluid flow path (38) formed in the cold plate (30), wherein the fluid flow path is operable to receive the thermal management fluid.

5. The thermal management system of claim 4, wherein the phase change material (36) is positioned centrally between the fluid flow path (38) and the directed energy weapon (22).

6. The thermal management system of claim 4 or 5, wherein the fluid flow path (38) further comprises an inlet (40) arranged at a first side (42)_of the cold plate (30) and an outlet (44) arranged at a second side (46) of the cold plate, the second side being distinct from the first side.

7. The thermal management system of any preceding claim, wherein the directed energy weapon (22) is operable in a firing mode, and during operation in the firing mode, an amount of heat generated by the directed energy weapon exceeds an amount of heat that can be removed from the heat transfer assembly by the thermal management fluid.

8. The thermal management system of claim 7, wherein during operation in the firing mode, the phase change material (36) is operable to transform from a first state to a second state; optionally
wherein the first state is a solid and the second state is a liquid.

9. The thermal management system of claim 8, wherein the directed energy weapon (22) is operable in a charging mode, and during operation in the charging mode, the amount of heat that can be removed by the thermal management fluid exceeds the amount of heat generated by the directed energy weapon.

10. The thermal management system of claim 9, wherein during operation in the charging mode, the phase change material (36) is operable to transform from the second state to the first state.

11. The thermal management system of any preceding claim, wherein the phase change material (36) is a wax; and/or
wherein the secondary system (26) is one of a vapor cycle and an air cycle; and/or
wherein the secondary system (26) further comprises a heat exchanger and the thermal management system is thermally coupled to the heat exchanger.

12. A method of operating a thermal management system (20) for a directed energy weapon (22), the method comprising:
circulating a thermal management fluid (R) through a closed loop system thermally coupled to the directed energy weapon at a heat transfer assembly including a cold plate (30) and a phase change material (36);
operating the directed energy weapon in a firing mode, operating in the firing mode further comprising:
transferring heat from the directed energy weapon to the cold plate and the phase change material;
removing heat from the phase change material via the thermal management fluid; and
exhausting the heat of the thermal management fluid to a secondary system.

13. The method of claim 12, wherein during operation of the directed energy weapon (22) in the firing mode, transforming the phase change material (36) from a first state to a second state.

14. The method of claim 13, further comprising transforming the directed energy weapon (22) from the firing mode to a charging mode in response to substantially all of the phase change material (36) within the heat transfer assembly transforming from the first state to the second state; optionally
wherein the directed energy weapon does not generate heat during the charging mode.

15. The method of claim 14, wherein operating the directed energy weapon in the charging mode further comprises:
removing heat from the phase change material (36) via the thermal management fluid; and
exhausting the heat of the thermal management fluid to the secondary system (26); optionally
wherein during operation of the directed energy weapon in the charging mode, transforming the phase change material from the second state to the first state.
